# EUROPEAN PATENT APPLICATION

(11) **EP 0 539 053 A1**
(43) Date of publication of application: **28.04.1993**
(21) Application number: 92309110.2
(22) Date of filing: 07.10.1992
(51) Int. Cl.: G06K 11/18, H05K 9/00

(54) **Handwritten - input stylus for an electronic device**

(30) Priority: 21.10.1991 US 779656
(71) Applicant: NCR INTERNATIONAL INC., Dayton, Ohio 45479 (US)
(72) Inventor: Baird, Robert Douglas, Cambridge, Ohio 43725 (US)
(74) Representative: Robinson, Robert George

(57) **Abstract**

The invention provides for a stylus (20) for use in entering handwritten information into an electronic device (50) by bringing one end (24) thereof into operative relation with a surface (76) of the electronic device (50). The stylus (20) is electrically connected via a conductor (60) to, and grounded with, the electronic device (50). The stylus (20) includes a hollow cylindrical barrel (26) made from slightly conductive plastic material which is capable of providing a slow discharge of electrostatic potential from a user through the conductor (60) in order to avoid an electrostatic shock to the user which would result from an otherwise rapid discharge of the electrostatic potential.

## Description

This invention relates to a handwritten-input stylus for an electronic device.

Handwriting input devices that use electrostatic or capacitive digitizer surfaces require some degrees of shielding within the stylus to prevent errors in signals describing the digitized position of the stylus due to the effects of the user's hand near the digitizer screen and/or the stylus tip. This shielding, often connected to signal or chassis ground, may be on the external surface of the stylus. When the user of the handwriting input device first picks up the stylus prior to use, he or she may be at a high electrostatic potential with respect to earth ground. This is especially the case during the winter months in climates where the relative humidity is low. The high electrostatic charge is quickly discharged through the stylus shielding to earth ground when the user comes into contact with any grounded external shielding material, resulting in an unpleasant electrostatic shock.

In a retail environment, the handwriting input device can be used to capture credit card or debit card account information and customer signature. In this application, the customer walk up to the unit, picks up the stylus, and typically uses it for a relatively short period of time, such as ten to twenty seconds. An uncomfortable electrostatic shock may be the most significant part of what the customer remembers about using the unit, and could therefore substantially reduce customer acceptance of this type of product. The use of carpeting in the retail environment, significantly increases the probability of occurrence of an unpleasant and sometimes painful shock from the electrostatic discharge. The process of walking across a carpet to reach the handwriting input device can, by itself, develop electrostatic potentials of greater than 10,000 volts on the body of the user.

It is an object of the present invention to provide a stylus which prevents the unpleasant electrostatic discharge mentioned above.

According to one aspect of the present invention there is provided a stylus for use in entering handwritten information into an electronic device , comprising an elongate body and a tip at one end thereof for use in operative relationship with a surface of said device , the elongate body being arranged for connection to ground so a to provide electrostatic shielding for said stylus , characterized in that said elongate body is at least partly formed of material which exhibits a resistance for controlling the rate of electrostatic discharge to ground when said stylus is initially grasped by a user so as to prevent said user experiencing an electrostatic shock.

According to another aspect of the present invention there is provided an electronic write capture apparatus characterized by a stylus as described above.

Advantageously, the invention provides for a stylus for use with an electronic device in which an electrostatic charge on a user is slowly discharged when the user grasps the stylus in order to prevent a shock to the user.

Further, the invention meets a requirement that the user must be discharged to earth ground potential by the time that he or she comes into contact with the external shielding of the stylus. The invention allows for this to occur at a slow enough rate (a low enough current) that the discharge cannot be felt by the user. In the present invention, slightly conductive plastic material for the non-shield material of the stylus may be employed. Use of such a material allows the user to be slowly discharged prior to coming in contact with the external shielding material.

The invention is described further hereinafter, by way of example only, with reference to the accompanying drawings in which:-
Fig. 1 is an elevational view of the stylus of the present invention;
Fig. 2 is an end view of the stylus of Fig. 1; and
Fig. 3 is a perspective view showing the stylus of Fig. 1 included in a system which also includes a signature capture device and a printer.

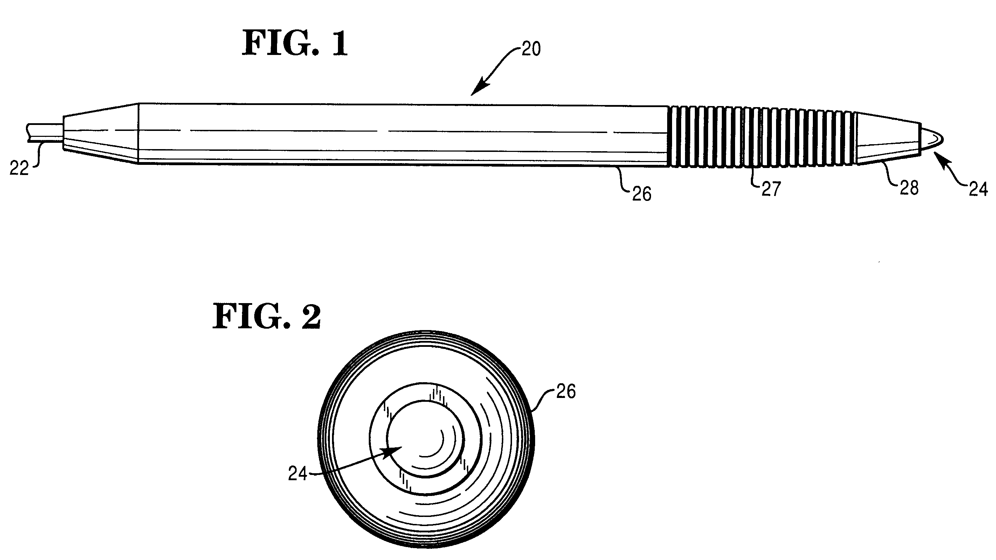

Referring now to Fig. 1, there is shown a stylus 20 constructed in accordance with the present invention. In the illustrated embodiment, the stylus 20 is generally cylindrical in shape, and is provided with an electrically conductive line or cable 22 at one end thereof, for connecting the stylus to ground and to electronic equipment with which is to be used. At its other end, the stylus 20 is provided with a tip 24, which is designed to be placed in operative relationship with electronic equipment for the entry of data thereto by movement of the stylus under control of a user. For example, the stylus 20 may be positioned so that its tip 24 is engaged with the surface of a digitizer.

The stylus 20 is provided with a central annular cylindrical portion or barrel 26, which may be provided with serrations 27 to facilitate being grasped with firm contact by a user. The user will move the stylus relative to the digitizer or other electronic device in order to enter information therein. Secured to the cylindrical portion 26 at the tip end of the stylus is a cap 28 of generally conical annular configuration.

The cap 28 is made from metal, such as aluminium, or other relatively highly conductive material, and is coupled through connections (not shown) and the cable 22 to the associated electronic system to provide a grounding of the tip area of the stylus 20. In use, the cap 28 is likely to be contacted by the fingers of a user after the user has initially grasped the stylus barrel 26, when the stylus is to be used for writing or marking of the digitizer or other surface of the associated electronic device.

In the normal manner of use of the stylus 20, the stylus will first be grasped by a user on the barrel 26. Since the user may very likely be carrying a substantial electrostatic charge, for the reasons previously described, it is highly desirable to avoid a shock to the user which might otherwise result from a rapid discharge of the electrostatic potential on the user when the user grasps the grounded stylus.

Such a shock is avoided in the present invention by making the barrel 26 of the stylus 20 from a material, such as a suitable plastic material, which is slightly conductive, so that the electrostatic charge is dissipated relatively slowly, at a sufficiently low current that it cannot be felt by the user. The user is thus slowly discharged prior to coming into contact with the external shielding cap 28. A surface resistivity of 10¹⁰ to 10¹² ohms per square will provide suitable resistive capabilities.

One suitable material is sold under the name of STAT-KON, type D-FR, available from LNP engineering Plastics division of ICI Americas, Inc., of Exton, PA. This plastic comprises a base material of ABS (acrylonitric butadiene styrene) with a filler or adder of 15% carbon powder. Another material which can be used, but which has been found to be somewhat less desirable from an electrical standpoint, is type PLN-SD, which is distributed by Polymerland, Lake Oswego, Oregon. This plastic also comprises a base material of ABS, to which a proprietary Permanent chemical additive is added. A third material which can be used, but which has been found to be somewhat less desirable from a standpoint of mechanical rigidity, is type M-1815, available from AKZO Engineering Plastics, Inc. of Evansville, Indiana. This plastic comprises a base material high impact polystyrene, with a filler/adder of polyether polymer. These materials are primarily designed to prevent build-up of electrostatic potential on plastic containers used for storage of explosives, flammable materials and military ordnance supplies. In addition, they can be used to protect sensitive electrical equipment from damage in the event of an electrostatic discharge.

Empirical data indicates that a person charged to an electrostatic potential of 10KV can be discharged to ground through 50 megohms of resistance without feeling discomfort. For a typical body capacitance of 120 PF, this results in a discharge duration of approximately 30 milliseconds. In an actual application with an electronic product, such as a business terminal employing a digitizer, a discharge duration of one second would be adequate. That is, the user would be discharged to an acceptable level (less than 100 volts) before coming into contact with any exposed or grounded metal of the electronic product. That would require a resistance to ground through the plastic barrel 26 of approximately 2 x 10⁹ ohms.

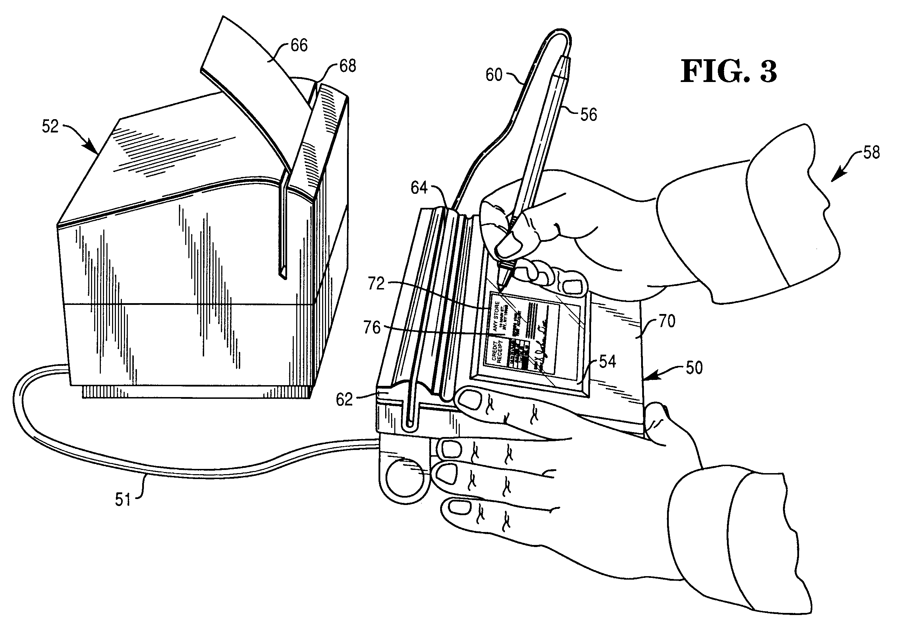

One arrangement in which the stylus 20 may be used is shown in Fig. 3, which is a perspective view of a signature capture or write input device 50, which is coupled to a printer 52 by a connector 51. The signature capture device 50 includes a transparent surface 54 through which information may be displayed and on which information may be entered by writing thereon with the stylus 56 by a human operator 58. The stylus 56 may take the form described in the present application and is connected to the remainder of the device 50 by an electrically conductive line 60. The device may also include an integral magnetic stripe reader 62 having a slot 64 through which a card bearing magnetic indicia may be swiped so that the data contained thereon can be entered into, stored in and used by the system which includes the write input device 50 and the printer 52. The write input device 50 can be configured without the magnetic stripe reader 62, if desired, in the event that the system which includes the device 50 does not require such a reader, or incorporates a separate reader.

The printer 52 will most commonly be used for printing customer receipts such as a receipt 66 which is shown as issuing from an aperture 68 in the housing of the printer. Other types of record media could also be generated by the printer 52, if desired, in response to the needs of the system.

The signature capture unit 50 is contained within a housing 70 which contains an aperture 72 within which is placed a transparent interactive digitizer element 76 which is capable of generating electrical signals which represent the position of the stylus 56. Broadly speaking, during operation of the interactive element 76, the stylus 56 acts as a probe and the differing potentials between sides of the element, in two coordinate directions, are measured, converted into digital form, and are processed through correction algorithms. This enables a trace of the movement of the stylus to be captured and retained, as well as displayed on a liquid crystal display module.

## Claims

1. A stylus (20) for use in entering handwritten information into an electronic device (50), comprising an elongate body (26) and a tip (24) at one end thereof for use in operative relationship with a surface (76) of said device (50), the elongate body (26) being arranged for connection to ground so a to provide electrostatic shielding for said stylus (20), characterized in that said elongate body (26) is at least partly formed of material which exhibits a resistance for controlling the rate of electrostatic discharge to ground when said stylus (20) is initially grasped by a user so as to prevent said user experiencing an electrostatic shock.

2. A stylus (20) according to claim 1, characterized by conductor means (22,60) coupled to the end of said stylus (20) opposite said tip (24) for connection of said body (26) to ground.

3. A stylus (20) according to claim 1 or 2, characterized in that said body (26) comprises a hollow cylindrical member.

4. A stylus (20) according to claim 1, 2 or 3, characterized in that said body is formed of acrylonitric butadiene styrene plastic with a filler of carbon powder.

5. A stylus (20) according to claim 1, 2 or 3, characterized in that said body (26) is formed of type D-FR, STAT-KON plastic.

6. A stylus (20) according to claim 1, 2 or 3, characterized in that said body (26) is formed of type PLN-SD plastic.

7. A stylus (20) according to claim 1, 2 or 3, characterized in that said body (26) is formed of type M-1815 plastic.

8. A stylus (20) according to claim 1, 2 or 3, characterized in that said body (26) is formed of high impact polystyrene, with a filler of polyether polymer.

9. A stylus (20) according to any one of the preceding claims, characterized in that the surface resistance of said body (26) is between 10¹⁰ and 10¹² ohms per square.

10. An electronic apparatus for receiving handwritten information, characterized by a stylus (20) according to any one of the preceding claims.
